(19) **Europäisches Patentamt / European Patent Office / Office européen des brevets**

(11) **EP 4 573 379 B1**

(12) # EUROPÄISCHE PATENTSCHRIFT

(45) Veröffentlichungstag und Bekanntmachung des Hinweises auf die Patenterteilung:
**24.09.2025  Patentblatt 2025/39**

(21) Anmeldenummer: **24789865.3**

(22) Anmeldetag: **10.10.2024**

(51) Internationale Patentklassifikation (IPC):
***G01R 33/389*** (2006.01)

(52) Gemeinsame Patentklassifikation (CPC):
**G01R 33/389;** G01R 33/56563

(86) Internationale Anmeldenummer:
**PCT/EP2024/078588**

(87) Internationale Veröffentlichungsnummer:
**WO 2025/078541 (17.04.2025 Gazette 2025/16)**

(54) **VERFAHREN ZUM BETREIBEN EINES NMR-MESSSYSTEMS UND NMR-MESSSYSTEMS MIT EINEM SCHNELL EINREGELBAREN NMR-LOCK REGLER**

METHOD FOR OPERATING AN NMR MEASUREMENT SYSTEM AND NMR MEASUREMENT SYSTEM HAVING AN NMR LOCK CONTROLLER WHICH CAN BE QUICKLY ADJUSTED

PROCÉDÉ POUR FAIRE FONCTIONNER UN SYSTÈME DE MESURE RMN ET SYSTÈME DE MESURE RMN COMPRENANT UN RÉGULATEUR DE VERROUILLAGE RMN À RÉGLAGE RAPIDE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **12.10.2023  DE 102023210033**

(43) Veröffentlichungstag der Anmeldung:
**25.06.2025  Patentblatt 2025/26**

(73) Patentinhaber: **Bruker Switzerland AG**
**8117 Fällanden (CH)**

(72) Erfinder: **HENSEL, Rolf**
**8008 Zürich (CH)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**EP-B1- 1 621 894**

• **GALUPPINI GIACOMO ET AL: "Towards a Model-Based Field-Frequency Lock for Fast-Field Cycling NMR", APPLIED MAGNETIC RESONANCE, SPRINGER VERLAG, VIENNA, AU, vol. 50, no. 8, 15 June 2019 (2019-06-15), pages 1025 - 1047, XP036836619, ISSN: 0937-9347, [retrieved on 20190615], DOI: 10.1007/S00723-019-01130-Y**
• **GALUPPINI G. ET AL: "Towards a Model-Based Field-Frequency Lock for NMR", IFAC-PAPERSONLINE, vol. 50, no. 1, 1 July 2017 (2017-07-01), DE, pages 13020 - 13025, XP093233966, ISSN: 2405-8963, DOI: 10.1016/j.ifacol.2017.08.1999**
• **HENRY P-G ET AL: "Field-Frequency locked in vivo proton MRS on a whole-body spectrometer", MAGNETIC RESONANCE IN MEDICINE, WILEY-LISS, US, vol. 42, no. 4, 1 January 1999 (1999-01-01), pages 636 - 642, XP002980292, ISSN: 0740-3194, DOI: 10.1002/(SICI)1522-2594(199910)42:4<636::AID-MRM4>3.0.CO;2-I**

**Beschreibung**

Die Erfindung betrifft ein Verfahren zum Betreiben eines NMR-Messsystems mit einem Hauptfeldmagneten zur Erzeugung eines statischen Hauptmagnetfelds in einer z-Richtung, einer Mess-HF-Spule zum Anregen von Kernspins einer Messsubstanz, einem NMR-Lock Regler zum Erfassen von Feld-Störungen und zum Erzeugen eines Korrekturfeldes mittels einer Kompensationsspule, wobei eine NMR-Lock-Regelung durchgeführt wird, bei der Spins von Atom-Kernen einer Referenzsubstanz angeregt werden.

NMR-Messsysteme benötigen ein äußerst stabiles statisches Magnetfeld, um die erforderliche Messgenauigkeit gewährleisten zu können. Um Magnetfeldschwankungen zu kompensieren, sind Verfahren zur Feldstabilisierung bekannt, die einen NMR-Lock-Regler verwenden, der die Kompensation der dynamischen Änderungen des Haupt-Magnetfelds regelt, welche die NMR-Messung stören würden. Dabei werden die Kern-Spins von bestimmten Isotopen (zum Beispiel Deuterium) einer Referenz-Substanz (zum Beispiel Wasser) in der zu messenden Substanz in regelmäßigen Abständen angeregt, und die störende Feld-Abweichung wird aus dem Quotienten der beiden gemessenen Spin-Magnetisierungs-Vektor-Komponenten ($M_y/M_x$) berechnet. Anhand der so ermittelten Feld-Abweichung wird dann in einer Kompensationsspule ein entsprechendes Kompensationsfeld erzeugt, das die Abweichung möglichst gut kompensiert. Derartige Systeme sind aus [1], [2], [3] bekannt. Weiterhin sind derartige Systeme aus den Publikationen Galuppini et al, Applied Magnetic Resonance, 50(8):125-1047, 2019, Galuppini et al, IFAC-PapersOnLine 50(1):13020-13025, 2017 und Henry et al, Magn Reson Med 42(4):636-642, 1999 bekannt.

Die in [1], [2], [3] erwähnten Systeme beschreiben Verfahren zur FeldStabilisierung in einem geschlossenen Regelkreis, bei dem die Spin-Magnetisierung des Referenzisotops als Messgröße herangezogen und ein entsprechender Strom als Regelgröße zur Kompensation der Störungen in eine zusätzliche Spule (H0-Spule/Kompensationsspule) eingespeist wird. Die genannten Verfahren gehen davon aus, dass sich das System bereits in einem Gleichgewichts-Zustand befindet bzw. dass die Amplitude der y-Komponenten My der Spinmagnetisierung klein ist im Verhältnis zur Amplitude der x-Komponenten Mx der Spinmagnetisierung .

Beim Starten der NMR-Lock-Regelung ist dies jedoch nicht der Fall. Zu Beginn der NMR-Lock-Regelung wird mit einer erhöhten Leistung angeregt, um das Anwachsen der x-Komponente der Spinmagnetisierung zu beschleunigen. Dabei schießt diese jedoch über den angestrebten Gleichgewichtswert hinaus und erreicht diesen erst mit entsprechender Verzögerung. Es sind nicht publizierte Verfahren bekannt, bei denen zum Starten des NMR-Lock-Reglers unterschiedliche Regel-Parameter gewählt werden, um die nicht optimalen Verhältnisse während der Start-Phase auszugleichen.

Darüber hinaus sehen die bekannten Verfahren keine Maßnahmen vor, die nach Störungen durch das NMR-Puls-Programm (Gradienten, Entkoppelung, etc.), welche die Spin-Magnetisierung aus dem Gleichgewichtszustand bringen können, ergriffen werden. Gradienten-Pulse beispielsweise können die Spin-Magnetisierung in der X-Y-Ebene beeinflussen. Ist der Gradienten-Puls genügend stark und genügend lang, dann wird dadurch die Spin-Magnetisierung unkontrolliert "ausgelöscht". Das Einschwingen der Spin-Magnetisierungs-Vektoren nach einem solchen Gradientenpuls dauert daher entsprechend lange. In diesen Phasen des Einschwingens funktioniert die NMR-Lock-Regelung jeweils nicht optimal. Bei in kurzen Abständen wiederholten Störungen durch bspw. Anwenden von Gradientenpulsen oder wenn der Hochfrequenz-Kanal, der normalerweise für die Lock-Regelung vorgesehen ist (Lockkanal), zwischendurch für die eigentliche NMR-Messung verwendet wird, zum Beispiel für die Entkoppelung, verliert man dadurch Messgenauigkeit.

Aufgabe der Erfindung

Es ist Aufgabe der Erfindung, ein Verfahren zum Betreiben eines NMR-Messsystems sowie ein entsprechendes NMR-Messsystems bereitzustellen, das erlaubt, schneller mit der NMR-Messung zu beginnen und/oder das bei NMR-Messungen mit Gradienten und/oder Entkoppelung die Messgenauigkeit verbessert.

Beschreibung der Erfindung

Diese Aufgabe wird erfindungsgemäß gelöst durch ein Verfahren nach Anspruch 1 und ein NMR-Lock-System nach Anspruch 12.

Bei dem erfindungsgemäßen Verfahren wird ein HF-Puls angewendet, dessen Stärke so gewählt wird, dass die x-Komponente der Spin-Magnetisierung M der Referenzsubstanz unmittelbar nach dem Ende des HF-Pulses der x-Komponente Mxeq der Spin-Magnetisierung im Lock-Gleichgewichtszustand bei einer gewünschten Lock-Anregungsleistung entspricht, wobei die x-Komponenten Mx und Mxeq der Spin-Magnetisierung in einer x-Richtung ausgerichtet sind, die senkrecht zur z-Richtung liegt. Erfindungsgemäß wird also durch Einstrahlen eines gezielten HF-Pulses der Gleichgewichtszustand im Lock-Betrieb (Lock-Gleichgewichtszustand) der Spin-Magnetisierung (also der Zustand der Spin-Magnetisierung, in dem Längsmagnetisierung Mz und x-Komponente Mx der Magnetisierung im Lock-Gleichgewichtszustand konstant gehalten werden) hergestellt, um dann unmittelbar mit der NMR-Lock-Regelung zu beginnen. Durch das erfindungsgemäße Anwenden des HF-Pulses wird die Spin-Magnetisierung vorzeitig in ihren Lock-Gleichgewichtszustand "gedrängt". Somit wird eine beschleunigte Erreichung des Gleichgewichtszustands für die aktive NMR-Lock-Regelung aus dem Ruhezustand heraus bzw. nach starken Störungen durch bspw. GradientenPulsen erreicht. Das erfindungsgemäße Verfahren ergänzt die bereits bekannten Lock-Verfahren und ermöglicht, dass der Lock-Gleichgewichtszustand nach Störereignissen schnell erreicht werden kann. Mit dem erfindungsgemäßen Verfahren können bestehende Lock-Verfahren verbessert werden.

Die Stärke des HF-Pulses wird so gewählt, dass der HF-Puls die Spinmagnetisierung in einen Zustand bringt, bei dem deren x-Komponente der x-Komponente der Magnetisierung im Lock-Gleichgewichtszustand mit einer gewünschten Lock-Anregungsstärke entspricht. Die Stärke des HF-Pulses wird vorzugsweise vorab durch eine an sich bekannte Kalibrationsmessung zur Pulskalibrierung bestimmt.

Die Referenz-Substanz (typischerweise eine Deuterium-Verbindung) kann je nach Probenkopf-Bauart mit derselben Spule angeregt werden wie die zu messende Substanz, also mit der Mess-HF-Spule, oder aber mit einer weiteren Spule, welche dazu eingerichtet ist, Kernspins der entsprechenden Referenzsubstanz anzuregen. Die Referenzsubstanz wird auch als Lock-Substanz bezeichnet.

Eine NMR-Lock-Regelung umfasst:

- Anregen eines Spin-Systems von Atom-Kernen der Referenzsubstanz, vorzugsweise in regelmäßigen Abständen,

- Erfassen der Feld-Störungen (Störsignale) durch Ermittlung einer Abweichung zwischen der Phase der von der Referenzsubstanz ausgesendeten Signale und deren Soll-Phase mittels eines Felddetektors des NMR-Lock-Reglers,

- Übertragung der erfassten Feld-Störungen an die Regelelektronik der Kompensationsspule,

- Erzeugung eines Korrekturfeldes mittels der Kompensationsspule.

Bei einer bevorzugten Variante betragen die x-Komponente Mx und die y-Komponente My der Spin-Magnetisierung M der Referenzsubstanz vor dem Anwenden des HF-Pulses 0, wobei die y-Komponente My der Spin-Magnetisierung M entlang einer y-Richtung ermittelt wird, die senkrecht zur z-Richtung und zur x-Richtung liegt. Die Spin-Magnetisierung ist bei dieser Verfahrensvariante vor dem Anwenden des HF-Pulses also in z-Richtung ausgerichtet. Hierbei kann es sich um einen Gleichgewichtszustand ohne Anregung (Spin-Magnetisierung = Ruhemagnetisierung vor Beginn der NMR-Lock-Regelung) handeln oder um einen Nicht-Gleichgewichtszustand, der aus dem Zustand mit Lock-Anregung (während der NMR-Lock-Regelung) durch das Anwenden eines HF-Pulses erreicht wird.

Bei einer ersten Variante des erfindungsgemäßen Verfahrens wird der HF-Puls vor dem Start des NMR-Lock Reglers angewendet. Startzustand der Spin-Magnetisierung ist also die Ruhemagnetisierung (Gleichgewichtszustand ohne Anregung). Durch Einstrahlen des HF-Pulses wird die Richtung der Spin-Magnetisierung so verkippt, dass deren x-Komponente genau so groß ist, wie die x-Komponente der Spin-Magnetisierung, die sich langfristig einstellt bei einer Lock-HF-Anregung mit der Feldstärke B1, die der Rotations-Frequenz ω1 der Spin-Magnetisierung der Referenzsubstanz entspricht.

Die Spin-Magnetisierung der Referenzsubstanz kann somit unmittelbar vor dem initialen Start der NMR-Lock-Regelung auf einen "optimalen" Winkel gebracht werden, d.h. in einer Zeit, die sehr klein ist im Verhältnis zu den Zeitkonstanten des Spin-Systems, die im Bereich von ein paar hundert Millisekunden bis ein paar Sekunden liegen. In Realität kann die Spin-Magnetisierung der Referenzsubstanz innerhalb weniger Mikrosekunden auf einen "optimalen" Winkel gebracht werden, so dass die Mx-Komponente der Spin-Magnetisierung der Referenzsubstanz bereits beim Start der NMR-Lock-Regelung den Gleichgewichts-Wert Mxeq aufweist.

Die Ausrichtung der Spin-Magnetisierung M der Referenzsubstanz wird bei dieser Variante vorzugsweise um einen Winkel $\alpha$ geändert, der von den beiden Zeitkonstanten T1, T2 der Referenzsubstanz und von der Stärke der NMR-Lock-Anregung k (s. unten) abhängt. $\alpha$ ist dabei der Winkel zwischen der z-Richtung und dem durch den HF-Puls "verkippten Ruhemagnetisierungs-Vektor", also dem Vektor der Spin-Magnetisierung mit Betrag der Ruhemagnetisierung vor Einstrahlung des HF-Pulses, und mit x-Komponente der Magnetisierung im Lock-Gleichgewichtszustand). Die z-Komponente der Spin-Magnetisierung reduziert sich dann auf den Gleichgewichtswert Mzeq. Es kommt also nach der Verkippung der Richtung der Spin-Magnetisierung durch den HF-Puls zu einer Verkürzung und Drehung (weitere Verkippung) des Spin-Magnetisierungs-Vektors bei etwa gleichbleibender (leichte Schwankungen ausgenommen) Mxeq - Komponente. Nachdem die z-Komponente der Spin-Magnetisierung den Gleichgewichtswert erreicht hat, weist die Richtung der Spin-Magnetisierung einen Winkel β (= Gleichgewichtswinkel) gegenüber der z-Achse auf.

Vorzugsweise wird der Winkel $\alpha$ wie folgt gewählt:

$$\sin(\alpha) = \frac{k}{1+k^2}\sqrt{\frac{T_2}{T_1}}$$

Der Winkel $\alpha$ wird vorab anhand der Zeitkonstanten T1 und T2 der für den NMR-Lock-verwendeten Referenzsubstanz und von der Stärke der NMR-Lock-Anregung k ermittelt. Die Stärke der NMR-Lock-Anregung k liegt im Bereich von 0 bis 1, wobei mit k = 1 der Wert Mxeq der x-Komponente der Gleichgewichts-Spin-Magnetisierung der Referenzsubstanz maximal wird. Der Wert k kann für die vom Anwender gewählte Lock-Anregungsleistung beispielsweise anhand der nachstehenden Formel ermittelt werden:

$$k = \omega_1 \sqrt{T_1\, T_2}$$

, mit ω1: Rotations-Frequenz der Spin-Magnetisierung der Referenzsubstanz aufgrund der Lock-HF-Anregung mit der Feldstärke B1.

wobei der Zusammenhang zwischen Anregungs-Amplitude und Winkelgeschwindigkeit durch eine Puls-Winkel-Bestimmung ermittelt werden und der Einfluss des Puls-Shapings für die Lock-Anregung berücksichtigt werden sollte.

Vorzugweise wird das nach Anwenden des HF-Pulses auftretende NMR-Signal detektiert und daraus eine Feld-Abweichung ermittelt, wobei die ermittelte Feldabweichung zum Erzeugen des Korrekturfeldes verwendet wird, bevor der Lock-Regler eingeschaltet wird.

Bei einer zweiten Variante des erfindungsgemäßen Verfahrens wird der HF-Puls nach der Beendigung einer zu erwartenden Störung, insbesondere nach Anwendung eines Gradientenpulses eines Gradientensystems des NMR-Messsystems, angewendet, wobei die Ausrichtung der Spin-Magnetisierung M der Referenzsubstanz um einen Winkel β geändert wird, der von den beiden Zeitkonstanten T1, T2 der Referenzsubstanz und von der Stärke der NMR-Lock-Anregung k abhängt.

Nach der zu erwartenden/geplanten Feld-Störung (bspw. Gradienteneinstrahlung oder Spin-Entkoppelung) wird die Richtung der Spin-Magnetisierung also durch den erfindungsgemäßen HF-Puls aus der z-Achse in die Gleichgewichts-Magnetisierung Mxeq "verkippt".

Startzustand der Spin-Magnetisierung ist hier vorzugsweise eine Spin-Magnetisierung, die in z-Richtung ausgerichtet ist (Mx=0, My=0), deren Amplitude aber den Wert der Magnetisierung im Lock-Gleichgewichtszustand aufweist. Der Winkel β ist dann der Winkel zwischen der Richtung der Magnetisierung im Lock-Gleichgewichtszustand und der z-Richtung. Der Winkel β kann vorab anhand der Zeitkonstanten T1 und T2 der für den NMR-Lockverwendeten Referenzsubstanz und von der Stärke der NMR-Lock-Anregung k ermittelt werden.

Vorzugsweise wird vor der zu erwartenden Störung durch Anwenden eines vorausgehenden HF-Pulses die Spin-Magnetisierung M der Referenzsubstanz aus dem Gleichgewichtszustand im Lock-Betrieb (Lock-Gleichgewichtszustand) in einen temporären Zustand gebracht, in dem die x-Komponente Mx sowie die y-Komponente My der Spin-Magnetisierung M den Wert 0 aufweisen. Der temporäre Zustand dient einerseits dazu, die Transversalmagnetisierung vor dem Auftreten der zu erwartenden Störung zu beseitigen und gleichzeitig dabei die Magnetisierungsamplitude zu erhalten. Der temporäre Zustand kann daher auch als "Magnetisierungsamplituden-Konservierungs-Zustand" bezeichnet werden. Durch dieses Anwenden des vorausgehenden HF-Pulses vor der zu erwartenden Feld-Störung (Gradient) oder Entkoppelung wird die Richtung der Gleichgewichts-Magnetisierung Mxeq mit einem HF-Puls in die z-Achse geklappt. Da durch das Anwenden von Gradienten in der Regel nur die x-Komponente der Spin-Magnetisierung beeinflusst wird, nicht jedoch die z-Komponente, wird durch das "Zurückklappen" der Spin-Magnetisierung in z-Richtung die Spin-Magnetisierung aus dem Einflussbereich der Störung gebracht. Der vorausgehende HF-Puls bewirkt also ein kontrolliertes "Wegschalten" der x-Komponenten der Spin-Magnetisierung und verhindert damit, dass die Feld-Störung die x-Komponenten der Spin-Magnetisierung unkontrolliert beeinflussen kann. Durch das kontrollierte "Wegschalten" der x-Komponenten der Spin-Magnetisierung (Umklappen der Spin-Magnetisierung aus dem Lock-Gleichgewichtszustand auf die z-Achse) wird die Spin-Magnetisierung in einen definierten Zustand (Mx=0, My=0) gebracht, aus dem sie nach Beendigung der Störung wieder schnell in den Lock-Gleichgewichtszustand gebracht werden kann, da der hierfür benötigte Winkel β bereits bekannt ist.

Der vorausgehende HF-Puls ist zum HF-Puls nach Beendigung der zu erwartenden Störung invers (bewirkt also ein Verkippen der x-Komponente Mx der Spin-Magnetisierung um den Winkel -β) und kann durch die Mess-HF-Spule oder durch eine weitere HF-Spule eingestrahlt werden.

Der Wert des Winkels β kann anhand der Zeitkonstanten T1 und T2 der für den NMR-Lock verwendeten Referenzsubstanz und der Stärke der NMR-Lock-Anregung k ermittelt werden.

Vorzugsweise wird der Winkel β wie folgt gewählt:

$$\tan(\beta) = k\sqrt{\frac{T2}{T1}}$$

Die Erfindung betrifft auch ein NMR-Lock-System gemäß Anspruch 12, umfassend eine Kompensationsspule, einen NMR-Lock-Regler zum Erfassen von Feld-Störungen und zum Erzeugen eines Korrekturfeldes mittels der Kompensationsspule und eine HF-Spule, welche dazu eingerichtet ist, Kernspins einer Referenzsubstanz anzuregen. Erfindungsgemäß werden die Kompensationsspule und die zur Anregung von Kernspins der Referenzsubstanz eingerichtete HF-Spule von einer gemeinsamen Elektronik angesteuert.

Der NMR-Lock-Regler umfasst einen Lockkanal, d.h. einen zu einem nicht im NMR Lock-Regler vorhandenen Messkanal für die eigentliche NMR-Messung zusätzlichen Hochfrequenz-Kanal, der permanent und parallel zum eigentlichen NMR-Versuch die NMR-Signale der Referenzsubstanz misst und bei jeder Veränderung der Phase dieser Signale das Hauptmagnetfeld durch einen Korrekturstrom in der Kompensationsspule korrigiert. Der Lockkanal weist dazu Sende- und Empfangsfunktionalität auf. Die Kompensationsspule ist eine Spule für die Erzeugung eines statischen oder niederfrequenten Felds, das sich zum statischen Hauptmagnetfeld addiert.

Das erfindungsgemäße gemeinsame Ansteuern der Kompensationsspule und der zur Anregung von Kernspins der Referenzsubstanz eingerichtete HF-Spule hat den Vorteil, dass mit der HF-Spule die Abweichung des Feldes bestimmt werden kann (durch Phasen-Abweichung zwischen Sende- und Empfangs-Signal) und diese mit der Kompensations-Spule gleich 'weggeregelt' werden kann, ohne dass auf eine schnelle Datenverbindung zwischen zwei separaten ElektronikBaugruppen verzichtet werden kann. Somit kann das System einfacher und kostengünstiger gestaltet werden.

Erfindungsgemäß ist das erfindungsgemäße NMR-Lock-System dazu eingerichtet, das zuvor beschriebene Verfahren auszuführen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern die dadurch erhaltene Merkmalskombination in den durch die Ansprüche definierten Schutzumfang der Erfindung fällt. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Fig. 1    zeigt den Übergang der Spin-Magnetisierung aus dem thermischen Gleichgewichtszustand mit Mx=0 und My =0 in einen Zustand mit Mx=Mxeq, sowie in den Lock-Gleichgewichtszustand.

Fig. 2a   zeigt eine Pulssequenz mit einem initialen HF-Puls gemäß dem erfindungsgemäßen Verfahren sowie die simulierten aus der Referenzsubstanz erhaltenen NMR-Signale und den entsprechenden Verlauf der Spin-Magnetisierung.

Fig. 2b   zeigt eine Pulssequenz gemäß dem Stand der Technik sowie die simulierten aus der Referenzsubstanz erhaltenen NMR-Signale und den entsprechenden Verlauf der Spin-Magnetisierung.

Fig. 3    zeigt den Übergang der Spin-Magnetisierung zwischen einem Lock-Gleichgewichtszustand und einem Ungleichgewichtszustand mit Mx=0 und My =0.

Fig. 4    zeigt eine Pulssequenz mit einem HF-Puls gemäß dem erfindungsgemäßen Verfahren vor und nach eines Gradientenpulses sowie die aus der Referenzsubstanz erhaltenen NMR-Signale.

Fig. 5    zeigt schematisch den Aufbau eines erfindungsgemäßen NMR-Lock-Systems.

Bei dem erfindungsgemäßen Verfahren wird durch Einstrahlen eines gezielten HF-Pulses **1, 1'** der Lock-Gleichgewichtszustand der Spin-Magnetisierung erzwungen. Im Gegensatz zu HF-Pulsen **2,** die für die NMR-Lock-Regelung eingestrahlt werden, zeichnet sich der erfindungsgemäße HF-Puls 1, 1' dadurch aus, dass er die Verkippung der Magnetisierung um einen vorbestimmten Winkel bewirkt, sodass die x-Komponente ihren Gleichgewichtswert erreicht. Anhand des nach dem HF-Puls 1, 1' auftretenden NMR-Signals kann die aktuelle Feld-Abweichung ermittelt (mittels der Rotationsfrequenz um die z-Achse bzw. - mit einsetzendem Gleichgewichts-Zustand - mittels einer auftretenden Phasen-Abweichung) und das Feld korrigiert werden, bevor der Lock-Regler eingeschaltet wird.

Da die y-Komponente der Spin-Magnetisierung durch den Lock-Regler weggeregelt wird, also nur bei Störungen des Feldes vorhanden ist und wegen der Wirkung des Reglers sehr klein ist bzw. schnell wieder verschwindet, wird bei den nachfolgenden Betrachtungen angenommen, dass keine y-Komponente der Magnetisierung vorhanden ist, was im Wesentlichen dem Realzustand entspricht.

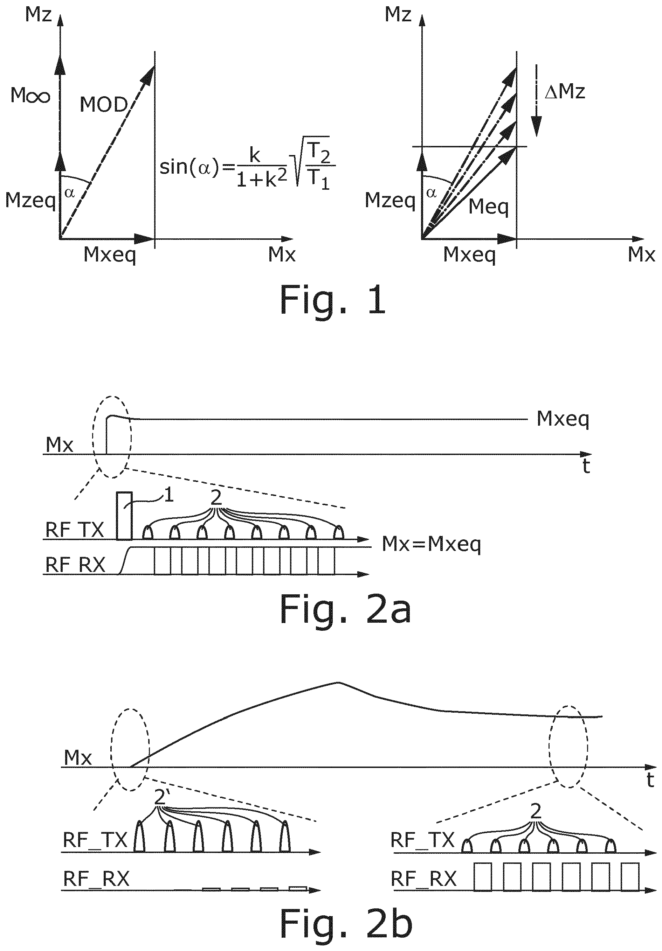

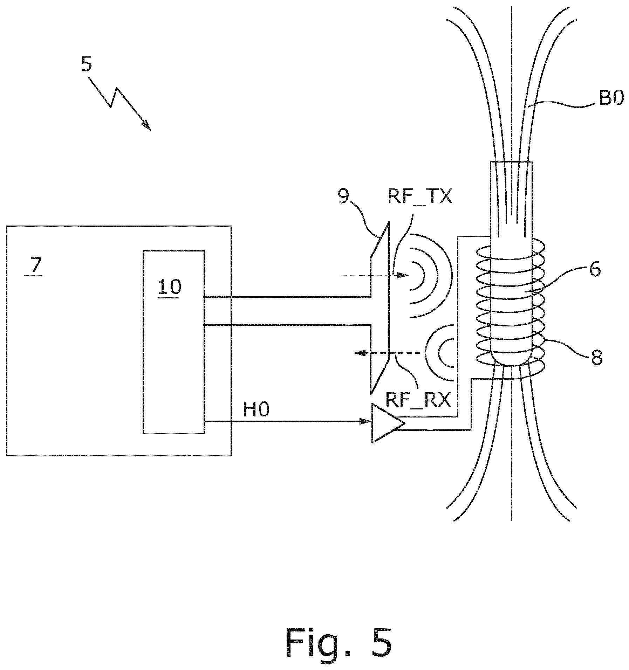

**Fig. 1** zeigt die Zustände der Spin-Magnetisierung der Referenzsubstanz **6** (s. Fig. 5) bei der ersten Variante des erfindungsgemäßen Verfahrens, bei der der erfindungsgemäße HF-Puls 1 eingestrahlt wird, bevor die NMR-Lock-Regelung mit ihren Lock-HF-Pulsen 2 gestartet wird. Die Kernspins der Referenzsubstanz 6 befinden sich in einem nicht-angeregten Zustand mit Ruhemagnetisierung **M∞** (M = M∞ = Magnetisierung im thermischen Gleichgewichtszustand, also ohne Anregung). Der Ruhemagnetisierungsvektor M∞ ist in z-Richtung (Richtung des statischen Hauptmagnetfelds B0) ausgerichtet.

Durch Einstrahlen des erfindungsgemäßen HF-Pulses 1 wird die Spin-Magnetisierung M∞ gegenüber der z-Richtung um den Winkel $\alpha$ verkippt, derart, dass sie eine x-Komponente **Mx** aufweist, die der x-Komponente **Mxeq** der Magnetisierung im Lock-Gleichgewichtszustand bei einer gewünschten Lock-Anregungsleistung entspricht. Der Betrag der Spinmagnetisierung nach dem Einstrahlen des erfindungsgemäßen HF-Pulses 1 entspricht zunächst dem der Ruhemagnetisierung M∞ (Fig. 1 links). Mit einer Verzögerung (abhängig von einer materialspezifischen Zeitkonstante) reduziert sich die z-Komponente der Spin-Magnetisierung um ∆**Mz** auf den Gleichgewichtswert Mzeq (Fig. 1 rechts), so dass sich schließlich die Gleichgewichtsmagnetisierung **Meq** mit Mx=Mxeq und Mz=Mzeq ergibt (Lock-Gleichgewichtszustand).

**Fig. 2a** zeigt auf der oberen Zeitachse einen schematischen Verlauf der Spin-Magnetisierung bei Anwendung des erfindungsgemäßen Verfahrens. Auf der mittleren Zeitachse sind die Anregungssignale **RF TX** einer Lock-Pulssequenz mit Lock-HF-Pulsen 2 (als Dome dargestellt) und einem initialen erfindungsgemäßen HF-Puls 1 (als Rechteck dargestellt) gezeigt. Die untere Zeitachse zeigt die zugehörigen MR-Signale **RF RX.**

**Fig. 2b** zeigt auf der oberen Zeitachse einen schematischen Verlauf der Spin-Magnetisierung bei Anwendung eines Verfahrens gemäß dem Stand der Technik. Auf der mittleren Zeitachse sind die Anregungssignale RF TX einer entsprechenden Lock-Pulssequenz gezeigt. Die Lock-Sequenz gemäß dem Stand der Technik umfasst initiale Lock-HF-Pulse 2' mit erhöhter Amplitude und "reguläre" Lock-HF-Pulsen 2. Die untere Zeitachse zeigt die zugehörigen empfangenen MR-Signale RF RX.

Der Vergleich der in Fig. 2a und Fig. 2b gezeigten Verläufe der Spin-Magnetisierung macht deutlich, dass bei Anwendung des erfindungsgemäßen Verfahrens der Lock-Gleichgewichtszustand wesentlich schneller erreicht wird als mit herkömmlichen Verfahren, bei denen zunächst mit einer erhöhten Leistung (initiale Lock-HF-Pulse 2') angeregt wird.

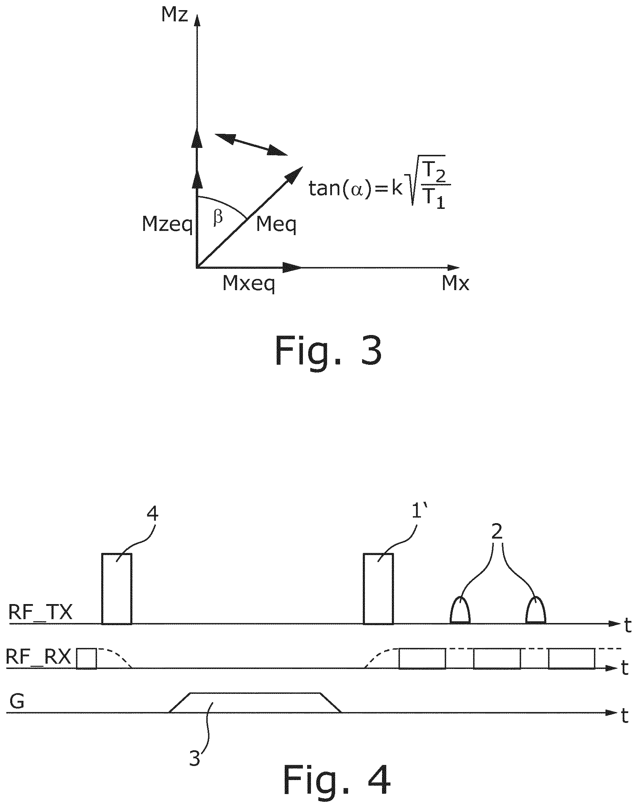

**Fig. 3** zeigt die Zustände der Spin-Magnetisierung der Referenzsubstanz bei einer zweiten Variante des erfindungsgemäßen Verfahrens, bei der vor einer Störung (hier: vor einem Gradientenpuls **3**) eine vorausgehender HF-Puls **4** und nach der Störung ein nachfolgender HF-Puls **1'** eingestrahlt wird. Der nachfolgende HF-Puls 1' sowie der vorausgehende HF-Puls 4 werden während des Lock-Betriebs eingestrahlt, um einerseits die Spin-Magnetisierung der Referenzsubstanz 6 aus dem Einflussbereich des Gradientenpulses 3 zu bringen, der ansonsten die Transversalmagnetisierung störend beeinflussen würde, und andererseits nach Beendigung der Störung möglichst schnell wieder eine Magnetisierung im Lock-Gleichgewichtszustand herzustellen, um einen zuverlässigen Lock-Betrieb zu gewährleisten.

Die Kernspins der Referenzsubstanz 6 befinden sich zunächst im Lock-Gleichgewichtszustand (Mx=Mxeq, Mz=Mzeq). Der Vektor der Magnetisierung Meq im Lock-Gleichgewichtszustand ist gegenüber der z-Achse um den Winkel $\beta$ geneigt. Durch Einstrahlen des vorausgehenden HF-Pulses 4 wird die Spin-Magnetisierung auf die z-Achse "geklappt", also um den Winkel $-\beta$ verkippt und somit in einen Magnetisierungsamplituden-Konservierungs-Zustand (Mx=0) gebracht, in dem der nachfolgende Gradientenpuls 3 keinen Einfluss auf die Spin-Magnetisierung hat. Der vorausgehende HF-Puls 4 bewirkt also ein Wegschalten der Transversalmagnetisierung. Nach Beendigung des Gradientenpulses 3 wird der nachfolgende HF-Puls 1' eingestrahlt, der eine Verkippung der Spin-Magnetisierung M gegenüber der z-Richtung um den Winkel $\beta$ bewirkt. Die Spinmagnetisierung wird also wieder zurück in den Lock-Gleichgewichtszustand gebracht (Mx=Mxeq, Mz=Mzeq). Der zeitliche Abstand das vorausgehenden HF-Pulses 4 und das nachfolgenden HF-Pulses 1' ist so klein gegenüber den Zeitkonstanten T1 und T2 des Spin-Systems, dass sich in dem temporären Zustand, in dem die x-Komponente der Spin-Magnetisierung Null ist, die Amplitude der Spin-Magnetisierung nicht bzw. nicht wesentlich ändert. Die Stärke des nachfolgenden HF-Pulses 1' kann daher gleich der Stärke des vorausgehenden HF-Pulses 4 gewählt werden.

**Fig. 4** zeigt auf der oberen Zeitachse die Anregungssignale **RF_TX** einer Lock-Pulssequenz mit Lock-HF-Pulsen 2 (als Dome dargestellt), dem vorausgehenden HF-Puls 4 und dem nachfolgendem HF-Puls 1' (jeweils als Rechteck dargestellt). Die mittlere Zeitachse zeigt die zugehörigen MR-Signale. Der Gradientenpuls 3 ist auf der unteren Zeitachse dargestellt

**Fig. 5** zeigt schematisch den Aufbau eines erfindungsgemäßen NMR-Lock-Systems **5** zur Durchführung des erfindungsgemäßen Verfahrens. Die für die NMR-Lock-Regelung verwendete Referenzsubstanz **6** befindet sich im Hauptmagnetfeld **B0,** welches von einem Hauptmagneten (nicht gezeigt) eines NMR-Messsystems erzeugt wird. Das NMR-Lock-System 5 umfasst einen NMR-Lock-Regler **7**, eine Kompensationsspule **8** und eine HF-Spule **9**, welche dazu eingerichtet ist, Kernspins einer Referenzsubstanz anzuregen und die Signale der Spins zu empfangen. Die Referenzsubstanz 6 befindet sich im Wirkbereich der HF-Spule **9,** mit der die Kernspins der Referenzsubstanz 6 angeregt und gemessen werden können, um störende Feld-Abweichungen zu detektieren. Die HF-Spule 9 ist vorzugsweise als Sattelspule ausgestaltet und in Fig. 5 nur schematisch angedeutet. Die Referenzsubstanz 6 befindet sich darüber hinaus im Wirkbereich der Kompensationsspule 8 zur Erzeugung eines Kompensationsfelds, mit dem das B0-Feld korrigiert werden kann. Die Kompensationsspule 8 und die HF-Spule 9 werden von einer gemeinsamen Elektronik **10** des NMR-Lock-Reglers 7 angesteuert.

Bezugszeichenliste

| | |
|---|---|
| 1 | initialer HF-Puls |
| 1' | HF-Puls nach Störung |
| 2 | Lock-HF-Puls |
| 2' | Lock-HF-Puls mit erhöhter Amplitude |
| 3 | Gradientenpuls |
| 4 | vorausgehender HF-Puls |
| 5 | NMR-Lock-System |
| 6 | Referenzsubstanz |
| 7 | NMR-Lock-Regler |
| 8 | Kompensationsspule |
| 9 | HF-Spule |
| 10 | Elektronik des NMR-Lock-Reglers |
| B0 | Hauptmagnetfeld |
| H0 | Kompensationskanal |
| RF_TX | Anregungssignal |

RF-RX Empfangssignal

Referenzliste

[1] EP 0 522 191 B1
[2] EP 1 887 375 B1
[3] EP 1 621 894 B1

**Patentansprüche**

1. Verfahren zum Betreiben eines NMR-Messsystems mit einem Hauptfeldmagneten zur Erzeugung eines statischen Hauptmagnetfelds B0 in einer z-Richtung, einer Mess-HF-Spule zum Anregen von Kernspins einer Messsubstanz, einem NMR-Lock Regler (5) zum Erfassen von Feld-Störungen und zum Erzeugen eines Korrekturfeldes mittels einer Kompensationsspule (8), wobei eine Lock-Regelung durchgeführt wird, bei der Spins von Atom-Kernen einer Referenzsubstanz (6) angeregt werden,
**dadurch gekennzeichnet,**
**dass** ein HF-Puls (1, 1') angewendet wird, dessen Stärke so gewählt wird, dass die x-Komponente der Spin-Magnetisierung M der Referenzsubstanz (6) unmittelbar nach dem Ende des HF-Pulses der x-Komponente Mxeq der Spin-Magnetisierung im Lock-Gleichgewichtszustand bei einer gewünschten Lock-Anregungsleistung entspricht, wobei die x-Komponenten Mx und Mxeq der Spin-Magnetisierung in einer x-Richtung ausgerichtet sind, die senkrecht zur z-Richtung liegt.

2. Verfahren nach Anspruch 1, **dadurch gekennzeichnet, dass** der Zustand, in dem die x-Komponente Mx der Spin-Magnetisierung den Wert Mxeq aufweist, durch Anwendung eines einzigen HF-Pulses (1, 1') erreicht wird.

3. Verfahren nach einem der vorhergehenden Ansprüche, **dadurch gekennzeichnet, dass** die x-Komponente Mx und die y-Komponente My der Spin-Magnetisierung der Referenzsubstanz (6) vor dem Anwenden des HF-Pulses (1, 1') Null betragen, wobei die y-Komponente My der Spin-Magnetisierung entlang einer y-Richtung ermittelt wird, die senkrecht zur z-Richtung und zur x-Richtung liegt.

4. Verfahren nach einem der vorhergehenden Ansprüche, **dadurch gekennzeichnet, dass** der HF-Puls (1) vor dem Start des NMR-Lock Reglers (5) angewendet wird.

5. Verfahren nach Anspruch 4, **dadurch gekennzeichnet, dass** die Ausrichtung der Spin-Magnetisierung der Referenzsubstanz (6) um einen Winkel $\alpha$ geändert wird, der von den beiden Zeitkonstanten T1, T2 der Referenzsubstanz (6) und von der Stärke k der NMR-Lock-Anregung abhängt, wobei

$$k = \omega_1 \sqrt{T_1\ T_2}$$

, mit $\omega 1$: Rotations-Frequenz der Spin-Magnetisierung der Referenzsubstanz (6) aufgrund der Lock-HF-Anregung mit der Feldstärke B1.

6. Verfahren nach Anspruch 5, **dadurch gekennzeichnet, dass** der Winkel $\alpha$ wie folgt gewählt wird:

$$\sin(\alpha) = \frac{k}{1 + k^2} \sqrt{\frac{T_2}{T_1}}$$

7. Verfahren nach einem der vorhergehenden Ansprüche, **dadurch gekennzeichnet, dass** nach Anwenden des HF-Pulses (1, 1') das auftretende NMR-Signal detektiert und daraus eine Feld-Abweichung ermittelt wird, wobei die ermittelte Feldabweichung zum Erzeugen des Korrekturfeldes verwendet wird, bevor der Lock-Regler (5) eingeschaltet wird.

8. Verfahren nach einem der vorhergehenden Ansprüche, **dadurch gekennzeichnet, dass** der HF-Puls (1') nach der Beendigung einer zu erwartenden Störung, insbesondere nach Anwendung eines Gradientenpulses (3) eines Gradientensystems des NMR-Messsystems, angewendet wird, wobei die Ausrichtung der Spin-Magnetisierung M der Referenzsubstanz (6) um einen Winkel $\beta$ geändert wird, der von den beiden Zeitkonstanten T1, T2 der Referenzsubstanz (6) und von der Stärke k der NMR-Lock-Anregung k abhängt.

9. Verfahren nach Anspruch 8, **dadurch gekennzeichnet, dass** vor der zu erwartenden Störung (3) durch Anwenden eines vorausgehenden HF-Pulses (4) die Spin-Magnetisierung M der Referenzsubstanz (6) aus dem Gleichgewichtszustand im Lock-Betrieb in einen temporären Zustand gebracht wird, in dem die x-Komponente Mx sowie die y-Komponente My der Spin-Magnetisierung M den Wert 0 aufweisen.

10. Verfahren nach Anspruch 8 oder 9, **dadurch gekennzeichnet, dass** der Wert des Winkels $\beta$ anhand der Zeitkonstanten T1 und T2 der für den NMR-Lock verwendeten Referenzsubstanz (6) und von der Stärke der NMR-Lock-Anregung k ermittelt wird.

11. Verfahren nach Anspruch 10, **dadurch gekennzeichnet, dass** der Winkel $\beta$ wie folgt gewählt wird:

$$\tan(\beta) = k\sqrt{\frac{T2}{T1}}$$

12. NMR-Lock-System (5) umfassend eine Kompensationsspule (8), einen NMR-Lock-Regler (7) zum Erfassen von Feld-Störungen und zum Erzeugen eines Korrekturfeldes mittels der Kompensationsspule (8) und eine HF-Spule (9), welche dazu eingerichtet ist, Kernspins einer Referenzsubstanz (6) anzuregen,
**dadurch gekennzeichnet, dass**

    die Kompensationsspule (8) und die zur Anregung von Kernspins der Referenzsubstanz eingerichtete HF-Spule (9) von einer gemeinsamen Elektronik (10) angesteuert werden, und dass das NMR-Lock-System (5) dazu eingerichtet ist, das Verfahren nach einem der Ansprüche 1 bis 10 auszuführen.

**Claims**

1. Method for operating an NMR measurement system having a main field magnet for generating a static main magnetic field B0 in a z direction, a measurement RF coil for exciting nuclear spins of a measurement substance, an NMR lock controller (5) for detecting field disturbances and for generating a correction field by means of a compensation coil (8), lock control being carried out, in which spins of atomic nuclei of a reference substance (6) are excited,
**characterized in that**
an RF pulse (1, 1') is applied, the strength of which is selected so that the x component of the spin magnetization M of the reference substance (6) immediately after the end of the RF pulse corresponds to the x component Mxeq of the spin magnetization in the lock equilibrium state at a desired lock excitation power, the x components Mx and Mxeq of the spin magnetization being oriented in an x direction which is perpendicular to the z direction.

2. Method according to claim 1, **characterized in that** the state in which the x component Mx of the spin magnetization has the value Mxeq is achieved by applying a single RF pulse (1, 1').

3. Method according to either of the preceding claims, **characterized in that** the x component Mx and the y component My of the spin magnetization of the reference substance (6) are zero before the RF pulse (1, 1') is applied, the y component My of the spin magnetization being established along a y direction which is perpendicular to the z direction and the x direction.

4. Method according to any of the preceding claims, **characterized in that** the RF pulse (1) is applied before the NMR lock controller (5) is started.

5. Method according to claim 4, **characterized in that** the orientation of the spin magnetization of the reference substance (6) is changed by an angle $\alpha$ which depends on the two time constants T1, T2 of the reference substance (6) and on the strength k
of the NMR lock excitation, where $k = \omega_1\sqrt{T_1 T_2}$, where $\omega 1$ is rotation frequency of the spin magnetization of the reference substance (6) due to the lock RF excitation with the field strength B1.

6. Method according to claim 5, **characterized in that** the angle $\alpha$ is selected as follows:

$$\sin(\alpha) = \frac{k}{1 + k^2}\sqrt{\frac{T_2}{T_1}}$$

7. Method according to any of the preceding claims, **characterized in that** after the RF pulse (1, 1') is applied, the occurring NMR signal is detected and a field deviation is determined therefrom, the determined field deviation being used to generate the correction field before the lock controller (5) is switched on.

8. Method according to any of the preceding claims, **characterized in that** the RF pulse (1') is applied after an expected disturbance is terminated, in particular after a gradient pulse (3) of a gradient system of the NMR measurement system is applied, the orientation of the spin magnetization M of the reference substance (6) being changed by an angle $\beta$ which depends on the two time constants T1, T2 of the reference substance (6) and on the strength k of the NMR lock excitation k.

9. Method according to claim 8, **characterized in that** before the expected disturbance (3), the spin magnetization M of the reference substance (6) is brought from the equilibrium state in lock mode into a temporary state in which the x component Mx and the y component My of the spin magnetization M have the value 0 by applying a preceding RF pulse (4).

10. Method according to claim 8 or 9, **characterized in that** the value of the angle $\beta$ is determined on the basis of the time constants T1 and T2 of the reference substance used for the NMR lock (6) and on the basis of the strength of the NMR lock excitation k.

**11.** Method according to claim 10, **characterized in that** the angle β is selected as follows:

$$\tan(\beta) = k\sqrt{\frac{T2}{T1}}$$

**12.** NMR lock system (5) comprising a compensation coil (8), an NMR lock controller (7) for detecting field disturbances and for generating a correction field by means of the compensation coil (8), and an RF coil (9) which is designed to excite nuclear spins of a reference substance (6),
**characterized in that**

the compensation coil (8) and the RF coil (9) designed to excite nuclear spins of the reference substance are actuated by a common electronics unit (10), and
**in that** the NMR lock system (5) is designed to carry out the method according to any of claims 1 to 10.

**Revendications**

**1.** Procédé de fonctionnement d'un système de mesure RMN avec un aimant de champ principal permettant de générer un champ magnétique principal statique BO dans une direction z, une bobine de mesure HF permettant d'exciter les spins nucléaires d'une substance de mesure, un régulateur de lock RMN (5) permettant de détecter des perturbations de champ et permettant de générer un champ de correction au moyen d'une bobine de compensation (8), dans lequel une commande de lock est mise en œuvre, grâce à laquelle les spins des noyaux atomiques d'une substance de référence (6) sont excités,
**caractérisé en ce que**

une impulsion HF (1, 1') est appliquée, dont l'intensité est choisie de sorte que
la composante x de la magnétisation de spin M de la substance de référence (6) immédiatement après la fin de l'impulsion HF correspond à la composante x Mxeq de la magnétisation de spin à l'état d'équilibre de lock pour une puissance d'excitation de lock souhaitée, dans lequel les composantes x Mx et Mxeq de la magnétisation de spin sont orientés dans une direction x perpendiculaire à la direction z.

**2.** Procédé selon la revendication 1, **caractérisé en ce que** l'état dans lequel la composante x Mx de la magnétisation de spin présente la valeur Mxeq est obtenu en utilisant une impulsion **HF** (1, 1') unique.

**3.** Procédé selon l'une quelconque des revendications précédentes, **caractérisé en ce que** la composante x Mx et la composante y My de la magnétisation de spin de la substance de référence (6) sont égales à zéro avant l'application de l'impulsion HF (1, 1'), dans lequel la composante y My de la magnétisation de spin est déterminée le long d'une direction y qui est perpendiculaire à la direction z et à la direction x.

**4.** Procédé selon l'une quelconque des revendications précédentes, **caractérisé en ce que** l'impulsion HF (1) est appliquée avant le démarrage du régulateur de lock RMN (5).

**5.** Procédé selon la revendication 4, **caractérisé en ce que** l'orientation de la magnétisation de spin de la substance de référence (6) est modifiée à raison d'un angle α qui dépend des deux constantes de temps T1, T2 de la substance de référence (6) et de l'intensité k de l'excitation de lock RMN, dans lequel

$$k = \omega_1\sqrt{T_1 T_2}$$ , avec ω1: fréquence de rotation de la magnétisation de spin de la substance de référence (6) en raison de l'excitation HF de lock avec l'intensité de champ B1.

**6.** Procédé selon la revendication 5, **caractérisé en ce que** l'angle α est choisi de la manière ci-dessous :

$$\sin(\alpha) = \frac{k}{1+k^2}\sqrt{\frac{T_2}{T_1}}$$

**7.** Procédé selon l'une quelconque des revendications précédentes, **caractérisé en ce que**, après l'application de l'impulsion HF (1, 1'), le signal RMN qui apparait est détecté et un écart de champ est déterminé à partir de celui-ci, dans lequel l'écart de champ déterminé est utilisé pour générer le champ de correction avant que le régulateur de lock (5) ne soit activé.

**8.** Procédé selon l'une quelconque des revendications précédentes, **caractérisé en ce que** l'impulsion HF (1') est appliquée après la fin d'une perturbation attendue, en particulier après l'application d'une impulsion de gradient (3) d'un système de gradient du système de mesure RMN, dans lequel l'orientation de la magnétisation de spin M de la substance de référence (6) est modifiée à raison d'un angle β qui dépend des deux constantes de temps T1, T2 de la substance de référence (6) et de l'intensité k de l'excitation de lock RMN.

9. Procédé selon la revendication 8, **caractérisé en ce que**, avant la perturbation (3) attendue, la magnétisation de spin M de la substance de référence (6) est amenée, grâce à l'application d'une impulsion HF (4) précédente, de l'état d'équilibre en mode de lock à un état temporaire dans lequel la composante x Mx et la composante y My de la magnétisation de spin M présentent la valeur 0.

10. Procédé selon la revendication 8 ou 9, **caractérisé en ce que** la valeur de l'angle β est déterminée à l'aide des constantes de temps T1 et T2 de la substance de référence (6) utilisée pour le lock RMN et à l'aide de l'intensité k de l'excitation de lock RMN.

11. Procédé selon la revendication 10, **caractérisé en ce que** l'angle β est choisi de la manière ci-dessous :

$$\tan(\beta) = k\sqrt{\frac{T2}{T1}}$$

12. Système de lock RMN (5) comprenant une bobine de compensation (8), un régulateur de lock RMN (7) permettant de détecter des perturbations de champ et de générer un champ de correction au moyen de la bobine de compensation (8), et une bobine HF (9) conçue pour exciter les spins nucléaires d'une substance de référence (6),
**caractérisé en ce que**

la bobine de compensation (8) et la bobine HF (9) conçue pour exciter les spins nucléaires de la substance de référence sont commandées par une électronique (10) commune, et
le système de lock RMN (5) est conçu pour mettre en œuvre le procédé selon l'une quelconque des revendications 1 à 10.

$$\sin(\alpha) = \frac{k}{1+k^2}\sqrt{\frac{T_2}{T_1}}$$

Fig. 1

Fig. 2a

Fig. 2b

$$tan(\alpha)=k\sqrt{\frac{T_2}{T_1}}$$

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0522191 B1
- EP 1887375 B1
- EP 1621894 B1

**In der Beschreibung aufgeführte Nicht-Patentliteratur**

- **GALUPPINI et al.** *Applied Magnetic Resonance*, 2019, vol. 50 (8), 125-1047
- **GALUPPINI et al.** *IFAC-PapersOnLine*, 2017, vol. 50 (1), 13020-13025
- **HENRY et al.** *Magn Reson Med*, 1999, vol. 42 (4), 636-642